Europäisches Patentamt

European Patent Office

Office européen des brevets

(19)

(11) Veröffentlichungsnummer: **0 299 215**

**A1**

(12) # EUROPÄISCHE PATENTANMELDUNG

(21) Anmeldenummer: **88109472.6**

(22) Anmeldetag: **14.06.88**

(51) Int. Cl.⁴: **H03L 5/00**

(30) Priorität: **17.07.87 DE 3723752**

(43) Veröffentlichungstag der Anmeldung:
**18.01.89 Patentblatt 89/03**

(84) Benannte Vertragsstaaten:
**DE FR GB IT NL**

(71) Anmelder: **Siemens Aktiengesellschaft Berlin und München**
**Wittelsbacherplatz 2**
**D-8000 München 2(DE)**

(72) Erfinder: **Fenk, Josef, Dipl.-Ing.**
**Deutenhauserstrasse 10**
**D-8057 Eching/Ottenburg(DE)**

(54) **Monolithisch integrierbare Reglerschaltung.**

(57) Reglerschaltung mit einem einzigen Signaleingang, bei der die Komponenten des Eingangsignales, die unterhalb einer bestimmten Frequenz liegen, durch die Gleichtaktunterdrückung eines Operationsverstärkers (Tf, Te, Th, Tg) eleminiert werden, in dem zur Beaufschlagung eines Einganges des Operationsverstärkers das gleichgerichtete Eingangssignal des Reglers vorgesehen ist und der andere Eingang des Operationsverstärkers mit dem zuvor tiefpaßgefilterten und dann gleichgerichteten (Tb, Td) Eingangsignal des Reglers beaufschlagt wird.

FIG 2

EP 0 299 215 A1

## Monolithisch integrierbare Reglerschaltung

Die Erfindung betrifft eine monolithisch integrierbare Reglerschaltung nach dem Oberbegriff des Patentanspruches 1.

Eine Reglerschaltung, bei der die Eingangssignale gleichgerichtet werden, bei der die unerwünschten, nicht zur Regelgröße gehörenden Signalanteile durch die Gleichtaktunterdrückung des Differenzverstärkereinganges einer Operationsverstärkerschaltung eliminiert werden und bei der eine Sollwerteinstellung vorgesehen ist, wird in der DE-PS 30 41 392 gezeigt.

In der vorgenannten DE-PS weist der Regler zwei Eingänge mit je einem Gleichrichter auf, die zur Beaufschlagung mit einem symmetrischen Ausgangssignal eines Differenzverstärkers und zur Vollweggleichrichtung dieses Signales vorgesehen sind. Der Ausgang jedes Gleichrichters ist jeweils mit einem Eingang eines Operationsverstärkers verbunden. Das Ausgangssignal des Operationsverstärkers und somit des Regelsystems ist proportional zu dem Differenzsignal der beiden Eingangssignale. Besteht das an beiden Eingängen anstehende Signal aus einem symmetrisch ausgekoppelten Differenzverstärkerausgangssignal mit einer Gegentakt-Wechselspannungskomponente sowie einem Gleichspannungsanteil und Störgrößen in Form von Gleichtakt-Wechselspannungskomponenten, so werden die Gleichtakt-Komponenten vom Regler unterdrückt und nur der Gegentakt-Anteil des Eingangssignals beeinflußt das Ausgangssignal des Reglers. Der Proportionalitätsfaktor zwischen Eingangsdifferenzsignal und Ausgangssignal und somit der Sollwert des Reglers wird in der Schaltung, die in der DE-PS 30 41 392, insbesondere in Figur 2, dargelegt ist, durch eine Gleichspannungsdifferenz zwischen den beiden Eingängen des Operationsverstärkers festgelegt. Diese Gleichspannungs differenz wird durch eine zusätzliche DC-Arbeitspunkteinstellung an mindestens einem Operationsverstärkereingang erzielt, die üblicherweise mehrere Widerstände enthält.

Nachteile einer Schaltung nach dem oben beschriebenen Stande der Technik sind der zusätzliche Bauteileaufwand zur Arbeitspunkteinstellung an den Operationsverstärkereingängen des Reglers und die direkte Abhängigkeit des tatsächlichen Sollwertes von der Konstanz der Arbeitspunktspannung des Oszillatorverstärkers. Außerdem ist die in der DE-PS 30 41 392 beschriebene Reglerschaltung nur für die Regelung von Differenzverstärkerpaaren mit symmetrischer Istwert-Auskopplung sinnvoll einsetzbar.

Aufgabe der Erfindung ist die Bereitstellung einer monolithisch integrierbaren Reglerschaltung mit einem einzigen Signaleingang, bei der die Komponenten des Eingangssignales, die unterhalb einer bestimmten Grenzfrequenz, z.B. unterhalb der gewünschten Signalfrequenz liegen, durch die Gleichtaktunterdrückung eines Operationsverstärkers eliminiert werden. Außerdem sollte der Bauteileaufwand verringert werden.

Diese Aufgabe wird bei einer Reglerschaltung der eingangs genannten Art durch die Merkmale des kennzeichnenden Teiles des Patentanspruches 1 gelöst.

Weiterbildungen der Erfindung sind in den Unteransprüchen beschrieben.

FIG 1 stellt ein Prinzipschaltbild der Schaltung nach Patentanspruch 1 dar.

FIG 2 beschreibt eine besonders günstige Ausführungsform der Erfindung.

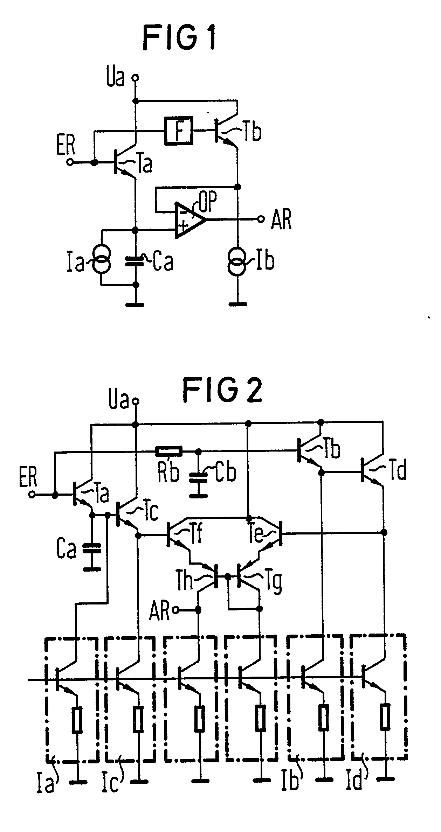

In FIG 1 wird eine Schaltung gezeigt, bei der der Basisanschluß eines ersten Transistors Ta mit einem Signaleingang ER der Reglerschaltung verbunden ist und der Basisanschluß eines zweiten Transistors Tb über einen Tiefpaß F ebenfalls an den Signaleingang geschaltet ist, bei der die Kollektoranschlüsse des ersten und des zweiten Transistors jeweils an ein Potential, insbesondere ein gemeinsames erstes Versorgungspotential Ua angeschlossen sind, bei der der Emitter des ersten Transistors Ta mit einem, insbesondere dem nichtinvertierenden Eingang eines Operationsverstärkers OP verbunden ist und über eine erste Kapazität Ca sowie über eine erste Konstantstromquelle Ia an das Bezugspotential (Masse) geschaltet ist, bei der der Emitter des zweiten Transistors Tb mit dem anderen, insbesondere dem invertierenden Eingang des Operationsverstärkers OP verbunden ist und außerdem über eine zweite Konstantstromquelle Ib an das Bezugspotential (Masse) geschaltet ist, bei der der Ausgang des Operationsverstärkers mit dem Ausgang AR des Reglers verbunden ist und bei der das Verhältnis des Stromes der zweiten Konstantstromquelle Ib zu dem Strom der ersten Konstantstromquelle Ia zur Sollwerteinstellung vorgesehen ist.

Durch geeignete Wahl des Stromes der ersten Konstantstromquelle Ia wird der erste Transistor Ta in dem Arbeitspunkt betrieben, in dem der Gleichrichterwirkungsgrad des Transistors optimal ist.

Wird also z.B. am Signaleingang ER der beschriebenen Schaltung ein Signal eingespeist, das sich aus Wechselspannungskomponenten und einer Gleichspannungskomponente zusammensetzt, so liegt dieses Signal unmittelbar am Basisanschluß des ersten Transistors Ta an und am Emitter des ersten Transistors Ta steht folglich eine Gleichspannung an, die sich aus den einweggleichgerichteten Komponenten aller Signalfrequenzen sowie dem Eingangssignal-Gleichspannungsanteil zusammensetzt. Am Basisanschluß des zweiten Transistors Tb liegt nur der Teil des Eingangssignales an, dessen Frequenz kleiner als die Grenzfrequenz des Tiefpaßfilters F ist. Die Anteile höherer Frequenz werden abgedämpft. Deshalb sind auch in der Gleichspannung, die am Emitter des zweiten Transistors Tb ansteht, keine Komponenten enthalten, die durch Gleichrichten von Signalen höherer Frequenzen herrühren. Das Signal am Emitter des ersten Transistors unterscheidet sich also von dem Signal am Emitter des zweiten Transistors, abgesehen von einem Faktor nur um den gleichge richteten Anteil des Eingangssignales, dessen Frequenz oberhalb der Grenzfrequenz des Tiefpasses F liegt. Die Gleichspannungskomponente des Eingangssignales sowie die Signalanteile, deren Frequenz unterhalb der Grenzfrequenz des Tiefpasses F liegt, werden in den Emitterausgangssignalen des ersten und des zweiten Transistors Ta, Tb in gleicher Weise berücksichtigt. Wird das Emitterausgangssignal des ersten Transistors Ta an dem nichtinvertierenden Eingang, das Emitterausgangssignal des zweiten Transistors Tb an dem invertierenden Eingang eines Operationsverstärkers OP eingespeist, so liefert der Ausgang dieses Operationsverstärkers OP die mit einem Faktor gewichteten Eingangssignalanteile, deren Frequenz höher als die Grenzfrequenz des Tiefpaßfilters ist. Die Gleichspannungskomponente und die niederfrequenten Störanteile des Eingangssignales der Schaltung sind aufgrund der hohen Gleichtaktunterdrückung des Operationsverstärkers OP nicht in dessen Ausgangssignal enthalten. Der Faktor, mit dem die höherfrequenten Eingangssignalkomponenten gewichtet werden, kann durch Wahl des Verhältnisses des Stromes der ersten Konstantstromquelle Ia zum Strom der zweiten Konstantstromquelle Ib vorgegeben werden. Die Variation dieses Stromverhältnisses ermöglicht also eine Sollwerteinstellung, es wird keine weitere Gleichspannungsaddition an einem der Eingänge des Operationsverstärkers benötigt.

Außerdem legt das Verhältnis der Ströme der ersten Konstantstromquelle Ia und der zweiten Konstantstromquelle Ib zueinander den Regelsinn fest. Durch Vertauschen der Operationsverstärkereingänge wird der Regelsinn umgekehrt.

FIG 2 zeigt eine besonders günstige Ausgestaltungsform der beschriebenen Reglerschaltung, die sich von der Schaltung nach FIG 1 dadurch unterscheidet, daß der Emitteranschluß des ersten Transistors Ta nicht unmittelbar mit dem einen Eingang des Operationsverstärkers OP, sondern unter Bildung einer Darlington-Stufe mit dem Basisanschluß eines dritten Transistors Tc verbunden ist, daß der Emitteranschluß dieses dritten Transistors Tc an den einen Eingang des Operationsverstärkers OP angeschlossen und über eine dritte Konstantstromquelle Ic an das Bezugspotential geschaltet ist, daß der Emitteranschluß des zweiten Transistors Tb nicht unmittelbar mit dem anderen Eingang des Operationsverstärkers OP, sondern unter Bildung einer Darlington-Stufe mit dem Basisanschluß eines vierten Transistors Td verbunden ist, daß der Emitteranschluß dieses vierten Transistors Td an den anderen Eingang des Operationsverstärkers OP angeschlossen und über eine vierte Konstantstromquelle Id an das Bezugspotential geschaltet ist, daß der Kollektor des dritten Transistors Tc und der Kollektor des vierten Transistors Td jeweils an ein Potential, insbesondere das erste Versorgungspotential Ua angeschlossen sind und daß insbesondere als invertierender Eingang des Operationsverstärkers OP der Basisanschluß eines fünften Tansistors Te und als nichtinvertierender Eingang des Operationsverstärkers OP der Basisanschluß eines sechsten Transistors Tf vom gleichen Typ vorgesehen ist, daß insbesondere der Kollektoranschluß des fünften Transistors und der Kollektoranschluß des sechsten Transistors an ein Potential, insbesondere das erste Versorgungspotential Ua angeschlossen sind, daß insbesondere der Emitter des fünften Transistors Te mit dem Emitter eines siebten Transistors Tg und der Emitter des sechsten Transistors Tf mit dem Emitter eines achten Transistors Th verbunden ist, wobei der Typ des siebten und des achten Transistors Tg, Th komplementär zum Typ des fünften und des sechsten Transistors Te, Tf ist, daß insbesondere die Basis des siebten Transistors Tg und die Basis des achten Transistors Th an den Kollektor des siebten Transistors Tg geschaltet sind, daß insbesondere die Kollektoren des siebten und des achten Transistors Tg, Th über je eine Konstantstromquelle an das Bezugspotential angeschlossen sind und der Kollektor des achten Transistors Th als Ausgang des Operationsverstärkers OP vorgesehen ist und daß insbesondere der Basisanschluß des zweiten Transistors Tb über einen zweiten Widerstand Rb mit dem Basisanschluß des ersten Transistors Ta und über eine zweite Kapazität Cb mit dem Bezugspotential verbunden ist.

Bei Schaltungen nach FIG 1 unterscheiden sich die Potentiale an den Operationsverstärkereingängen von dem Potential am Signal eingang der Regelschaltung gleichspannungsmäßig nur um die Spannung, die über einer Basis-Emitter-Strecke ansteht. Aufgrund dieser geringen Potentialdifferenz ist der Stellbereich des Reglers, der durch das Verhältnis des Stromes des ersten Transistors Ta zum Strom des zweiten Transistors Tb beeinflußt wird, begrenzt, denn aufgrund der logarithmischen Abhängigkeit des Stromes von der Spannung führt eine geringe Erhöhung der Spannungsdifferenz zu einer relativ großen Erhöhung der Stromdifferenz, eine zu hohe Stromdifferenz steht jedoch einer exakten Einstellbarkeit der Schaltung entgegen. Durch die beschriebene Hintereinanderschaltung des ersten und des dritten Transistors Ta, Tc bzw. des zweiten und des vierten Transistors Tb, Td liegen jeweils zwei Basis-Emitter-Strecken zwischen dem Signaleingang des Reglers und den Operationsverstärkereingängen. Um die gleiche Spannungsdifferenz zu erzielen ist dadurch zwischen den Strömen der Darlington-Stufen Ta, Tc und Tb, Td in Schaltungen nach FIG 2 eine erheblich geringere Stromdifferenz erforderlich, als zwischen den Strömen des ersten Transistors Ta und des zweiten Transistors Tb in Schaltungen nach FIG 1. In Schaltungen nach FIG 2 wird der Sollwert nicht nur durch das Verhältnis des Stromes der ersten Konstantstromquelle Ia zu dem Strom der zweiten Konstantstromquelle Ib bestimmt, sondern auch durch das Verhältnis des Verhältnisses des Stromes der dritten Stromquelle Ic zum Strom der ersten Stromquelle Ia zu dem Verhältnis des Stromes der vierten Stromquelle Id zu dem Strom der zweiten Stromquelle Ib.

Der Operationsverstärker ist in FIG 2 durch eine raumsparend aufbaubare Differenzverstärkerschaltung mit Stromspiegel und Konstantstromquelle realisiert.

Alle Konstantstromquellen können insbesondere, wie in FIG 2 gezeigt, jeweils als Transistor in Basisschaltung, dessen Emitter über einen Widerstand an das Bezugspotential geschaltet ist, dessen Basis mit einem konstanten Potential beaufschlagt wird und dessen Kollektor als Stromeingang vorgesehen ist, aufgebaut werden. Bei konstantem Basispotential wird hierbei der Strom der Stromquelle durch den Widerstand festgelegt. Sind alle Stromquellen auf diese Weise realisiert und liegen die Basisanschlüsse aller Stromquellentransistoren auf dem gleichen Referenzpotential, so kann im Bedarfsfall durch Beeinflussung des Referenzpotentiales die gesamte Schaltung stromlos geschaltet werden.

Als Tiefpaß F reicht in manchen Fällen, wenn die Grenzfrequenz des Tiefpasses genügend klein zur Signalfrequenz der Regelgröße gewählt werden kann, ein Filter erster Ordnung aus, das zwischen seinem Eingang und seinem Ausgang einen Widerstand vorgesehen hat und dessen Ausgang über eine Kapazität an das Bezugspotential angeschlossen ist.

**Ansprüche**

1. Monolithisch integrierbare Regler-Schaltungsanordnung, die insbesondere zur Amplitudenregelung bei Oszillatorverstärkern eingesetzt werden kann und bei der eine Istwerterfassung durch Gleichrichten, eine Eingangssignal-Mittelwertunterdrückung durch Verwendung einer Differenzverstärkeranordnung sowie eine Sollwert-Einstellung vorgesehen sind,

**dadurch gekennzeichnet,**

daß der Basisanschluß eines ersten Transistors (Ta) mit einem Signaleingang (ER) der Reglerschaltung verbunden ist und der Basisanschluß eines zweiten Transistors (Tb) über einen Tiefpaß (F) ebenfalls an den Signaleingang (ER) geschaltet ist, daß die Kollektoranschlüsse des ersten und des zweiten Transistors (Ta, Tb) jeweils an ein Potential angeschlossen sind, daß der Emitter des ersten Transistors mit einem Eingang eines Operationsverstärkers (OP) verbunden ist und über eine erste Kapazität (Ca) sowie über eine erste Konstantstromquelle (Ia) an das Bezugspotential (Masse) geschaltet ist, daß der Emitter des zweiten Transistors (Tb) mit dem anderen Eingang des Operationsverstärkers (OP) verbunden ist und außerdem über eine zweite Konstantstromquelle (Ib) an das Bezugspotential (Masse) geschaltet ist, daß der Ausgang des Operationsverstärkers (OP) mit dem Ausgang (AR) des Reglers verbunden ist und daß das Verhältnis des Stromes der zweiten Konstantstromquelle (Ib) zu dem Strom der ersten Konstantstromquelle (Ia) zur Sollwerteinstellung vorgesehen ist.

2. Schaltung nach Anspruch 1,

**dadurch gekennzeichnet,**

daß der Emitteranschluß des ersten Transistors (Ta) nicht unmittelbar mit dem einen Eingang des Operationsverstärkers (OP), sondern unter Bildung einer Darlington-Stufe mit dem Basisanschluß eines dritten Transistors (Tc) verbunden ist, daß der Emitteranschluß dieses dritten Transistors (Tc) an den einen Eingang des Operationsverstärkers (OP) angeschlossen und über eine dritte Konstantstromquelle (Ic) an das Bezugspotential (Masse) geschaltet ist, daß der Emitteranschluß des zweiten Transistors nicht unmittelbar mit dem anderen Eingang des Operationsverstärkers, sondern unter Bildung einer Darlington-Stufe mit dem Basisanschluß eines vierten Transistors (Td) verbunden ist, daß der Emitteranschluß dieses vierten Transistors (Td) an den anderen Eingang des Operationsverstärkers (OP) angeschlossen und über eine vierte Konstantstromquelle (Id) an das Bezugspotential geschaltet ist, daß der Kollektor des dritten Transistor (Tc) und der Kollektor des vierten Transistors (Td) jeweils an ein Potential angeschlossen sind und zusätzlich zu dem Verhältnis der Ströme der ersten Konstantstromquelle (Ia) zu dem Strom der zweiten Konstantquelle (Ib) auch das Verhältnis des Verhältnisses des Stromes der dritten Konstantstromquelle (Ic) zu dem Strom der ersten Konstantstromquelle (Ia) zu dem Verhältnis des Stromes der vierten Konstantstromquelle (Id) zu dem Strom der zweiten Konstantstromquelle (Ib) zur Sollwerteinstellung vorgesehen sind.

3. Schaltung nach Anspruch 1 oder 2,
**dadurch gekennzeichnet,**
daß die Kollektoranschlüsse des ersten und des zweiten Transistors (Ta, Tb) an ein gemeinsames erstes Versorgungspotential (U$_a$) angeschlossen sind.

4. Schaltung nach Anspruch 1, 2 oder 3,
**dadurch gekennzeichnet,**
daß der Emitter des ersten Transistors (Ta) mit dem nichtinvertierenden Eingang eines Operationsverstärkers (OP) verbunden ist und daß der Emitter des zweiten Transistors (Tb) mit dem invertierenden Eingang des Operationsverstärkers (OP) verbunden ist.

5. Schaltung nach Anspruch 1 , 2, 3 oder 4,
**dadurch gekennzeichnet,**
daß als invertierender Eingang des Operationsverstärkers (OP) der Basisanschluß eines fünften Tansistors (Te) und als nicht invertierender Eingang des Operationsverstärkers (OP) der Basisanschluß eines sechsten Transistors (Tf) vom gleichen Typ vorgesehen ist, daß der Kollektoranschluß des fünften Transistors (Te) und der Kollektoranschluß des sechsten Transistors (Tf) an ein Potential, insbesondere das erste Versorgungspotential (Ua) angeschlossen sind, daß der Emitter des fünften Transistors (Te) mit dem Emitter eines siebten Transistors (Tg) und der Emitter des sechsten Transistors (Tf) mit dem Emitter eines achten Transistors (Th) verbunden ist, wobei der Typ des siebten und des achten Transistors (Tg, Th) komplementär zum Typ des fünften und des sechsten Transistors (Te, Tf) ist, daß die Basis des siebten Transistors (Tg) und die Basis des achten Transistors (Th) an den Kollektor des siebten Transistors (Tg) geschaltet sind, daß die Kollektoren des siebten und des achten Transistors (Tg, Th) über je eine Konstantstromquelle an das Bezugspotential angeschlossen sind und der Kollektor des achten Transistors (Th) als Ausgang des Operationsverstärkers vorgesehen ist.

6. Schaltung nach einem der vorgenannten Ansprüche,
**dadurch gekennzeichnet,**
daß der Basisanschluß des zweiten Transistors (Tb) über einen zweiten Widerstand (Rb) mit dem Basisanschluß des ersten Transistors (Ta) und über eine zweite Kapazität (Cb) mit dem Bezugspotential (Masse) verbunden ist.

## FIG 1

## FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE-A-2 929 355 (DEUTSCHE ITT) * Seite 3, Zeile 14 - Seite 6, Zeile 21; Figuren 1,2 * --- | 1 | H 03 L 5/00 |
| A | US-A-4 588 968 (D.T. WILE) * Spalte 2, Zeile 25 - Spalte 4, Zeile 41; Figuren 1,2 * --- | 1 | |
| A,D | EP-A-0 051 179 (SIEMENS) * Zusammenfassung; Figur 1 * ----- | 1 | |
| | | | **RECHERCHIERTE SACHGEBIETE (Int. Cl.4)** H 03 L H 03 G |

Der vorliegende Recherchenbericht wurde für alle Patentansprüche erstellt

| Recherchenort | Abschlußdatum der Recherche | Prüfer |
|---|---|---|
| DEN HAAG | 17-10-1988 | DHONDT I.E.E. |